# EUROPEAN PATENT SPECIFICATION

(11) **EP 1 178 594 B1**
(45) Date of publication and mention of the grant of the patent: **12.08.2009**
(21) Application number: 01102031.0
(22) Date of filing: 30.01.2001
(51) Int. Cl.: H05K 7/20, H05K 1/02

(54) **Electronic apparatus provided with an electronic circuit substrate**
Elektronisches Gerät mit einem Substrat für die Schaltung
Appareil électronique avec un substrat pour circuit

(30) Priority: 01.08.2000 JP 2000232859
(43) Date of publication of application: 06.02.2002
(73) Proprietor: MITSUBISHI DENKI KABUSHIKI KAISHA, Chiyoda-ku Tokyo 100-8310 (JP)
(72) Inventor: Takano, Yorihira, Chiyoda-ku, Tokyo 100-8310 (JP)
(74) Representative: Pfenning, Meinig & Partner GbR

(56) References cited:
- EP-A- 0 827 373
- DE-C- 19 916 010
- JP-A- 08 204 070
- US-A- 5 352 926
- US-A- 5 946 544

## Description

### BACKGROUND OF THE INVENTION

### 1. Field of the Invention

The present invention relates to an electronic apparatus provided with an electronic circuit substrate, and in particular to a small electronic apparatus provided with an small electronic circuit substrate on which a heat generating component is mounted. Moreover, as an example of such a electronic apparatus provided with a small electronic circuit substrate an optical transceiver, which converts optical signals to electrical signals and transmits data, and the like may be given.

### 2. Description of the Related Art

In recent years, with miniaturization of electronic components and developments in high density integration technology, the size of optical transceivers, which are representative of electronic apparatuses provided with an electronic circuit substrate, has been decreasing at a rapid pace, and increases in the density of generated heat accompanying this reduction in size of electronic apparatuses provided with an electronic circuit substrate is beginning to be viewed as a problem. Furthermore, since electronic components are highly integrated, there is a tendency for the heat distribution inside electronic apparatuses provided with an electronic circuit substrate to concentrate in certain locations, and it is expected that this trend will strengthen further in the future. In consideration of the fact that size reductions in such electronic apparatuses provided with an electronic circuit substrate will lead to further increases in the density of generated heat and further concentration of the heat distribution, there is a need for development of an electronic apparatus provided with an electronic circuit substrate with improved heat dissipating characteristics.

When heat dissipation is carried out in an electronic apparatus provided with an electronic circuit substrate in which the density of generated heat increases and there is a concentration of the heat distribution, such as above, a ceramic substrate having good thermal conductivity and electrical characteristics has generally been employed as the substrate material, and the substrate is mounted by coating an adhesive and the like on the entire rear surface thereof and contacting to a case.

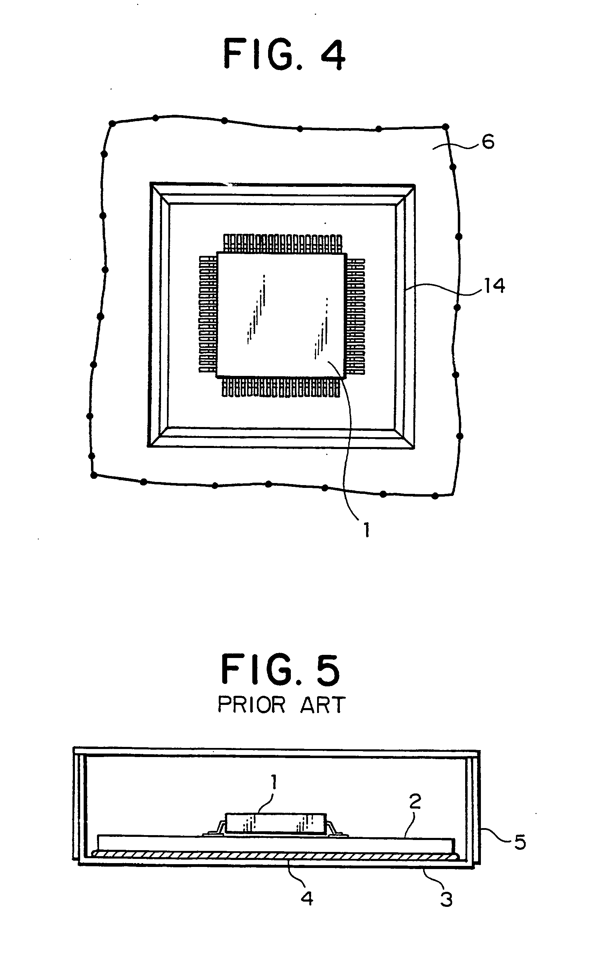

A construction of such a conventional electronic apparatus provided with an electronic circuit substrate is shown, for example, in FIG. 5.
In FIG. 5, a heat generating component 1 is a heat producing electronic component such as a power transistor, an electronic circuit substrate 2 constructed from a ceramic substrate mounts this heat generating component 1 on a surface thereof and a case 3 houses and protects the electronic circuit substrate 2, the case 3 being open at the upper side thereof so that the electronic circuit substrate 2 may be removed. An adhesive 4 fixes the electronic circuit substrate to the case 3 and a cover 5 covers the aforementioned opening.

In a conventional electronic apparatus provided with an electronic circuit substrate constructed as above, heat generated by the heat generating component 1 is diffused in the entire electronic circuit substrate 2 comprising a ceramic substrate with good thermal conductivity and the diffused heat is transferred to the case 3 via the adhesive 4. The case 3 functions as a radiator to dissipate the heat transferred thereto to the outside.
In this case, by using a ceramic substrate with good thermal conductivity as the electronic circuit substrate 2, the heat generated by the heat generating component is diffused through the entire substrate and since the diffused heat is transferred from the entire rear surface of electronic circuit substrate 2 contacting the case 3 to the case 3 which combines the effect of a radiator, heat is efficiently dissipated.

Nevertheless, in the electronic apparatus provided with an electronic circuit substrate constructed as above, a ceramic substrate is employed as the material of the electronic circuit substrate 2, and since the entire rear surface of the electronic circuit substrate 2 must be mounted so as to contact the case 3, there is a problem in that packaging density is reduced. Namely, when mounting a heat generating component 1 in an electronic apparatus provided with a small electronic circuit substrate, as stated above, ceramic material having good thermal conductivity is generally employed because it is necessary to dissipate heat and the electronic circuit substrate 2 is provided such that the entire rear surface thereof contacts with the case 3. Thus, electrical/electronic components are not normally mounted to the rear surface of the electronic circuit substrate 2. Moreover, assuming that packaging density is regarded as being important so that electrical/electronic components are also mounted on the rear surface of the electronic circuit substrate 2, since the electronic circuit substrate 2 is installed so as to be floating from the case 3, it is conceivable that, as ceramic does not have sufficient strength to withstand operating environment, such vibrations, shocks, etc. cracks and the like will develop in the ceramic substrate. Thus, conventionally, mounting of electrical/electronic components has been limited to one side of the electronic circuit substrate 2 and there has been a problem in that component packaging density has been reduced by half.

Moreover, there is also a problem in that the cost of the product increases because expensive ceramic must be used as the material of the electronic circuit substrate 2.

JP 08-204070 A discloses an electronic apparatus comprising an electronic circuit substrate, on which a heat generating part is mounted, and a heat radiating plate, wherein the electronic circuit substrate and the heat radiating plate are connected in the area below the heat generating part by a heat conducting body, while on both sides of the heat conducting body, a space is provided between the heat radiating plate and the electronic circuit substrate.

### SUMMARY OF THE INVENTION

The present invention aims to solve the above problems with the conventional art and the object of the present invention is to provide an electronic apparatus provided with an electronic circuit substrate which is inexpensive, with high packaging density and superior heat dissipating characteristics and reliability.

This object of the present invention is solved by the electronic apparatus according to claim 1 and the advantageous developments given by the dependent claim 2.

In order to achieve the above objects, according to one aspect of the present invention there is provided an electronic apparatus provided with an electronic circuit substrate comprising:
an electronic circuit substrate comprising a resin wiring substrate formed with a wiring pattern and a grounding pattern in an internal layer thereof, a plurality of through holes provided directly below a portion where a heat generating component is mounted and which are not connected to the grounding pattern, and opposing insulating grooves formed in a front and rear surface of the electronic circuit substrate so as to surround the heat generating component, and
a case for protectively housing the electronic circuit substrate provided with a heat dissipating protruding surface portion contacting an area where the through holes of the rear surface of the electronic circuit substrate are disposed, and being formed so as to ensure a space between the case and the rear surface of the electronic circuit substrate for enabling mounting of low heat generating electrical/electronic components.

According to the present invention there is provided an electronic apparatus provided with an electronic circuit substrate wherein:
a filler of a material with high thermal conductivity is filled in the plurality of through holes, and a heat dissipating grease intervenes at a contact portion between an area where the through holes of the electronic circuit substrate rear surface are disposed and the heat dissipating protruding surface portion of the case.

Moreover, in the present invention the heat generating component is an electrical/electronic component which generates a large amount of heat, such as a power transistor and the like, and the low heat generating electrical/electronic components are electrical/electronic components in which the amount of generated heat is smaller than in the heat generating component.

### BRIEF DESCRIPTION OF THE DRAWINGS

FIG. 1 is a schematic structural diagram of an electronic apparatus provided with an electronic circuit substrate according to Embodiment 1.
FIG. 2 is a schematic structural diagram of an electronic apparatus provided with an electronic circuit substrate according to Embodiment 2.
FIG. 3 is a schematic structural diagram of an electronic apparatus provided with an electronic circuit substrate according to Embodiment 3 of the present invention.
FIG. 4 is a plan view of the electronic circuit substrate described in FIG. 3.
FIG. 5 is a schematic structural diagram showing an example of a conventional electronic apparatus provided with an electronic circuit substrate.

### DETAILED DESCRIPTION OF THE PREFERRED EMBODIMENTS

Hereinafter, the present invention will be described in detail with reference to the accompanying drawings. Therein, only Embodiment 3 describes the present invention, the other embodiments describe aspects of the present invention and/or give background information necessary and/or helpful to understand the present invention.

### Embodiment 1

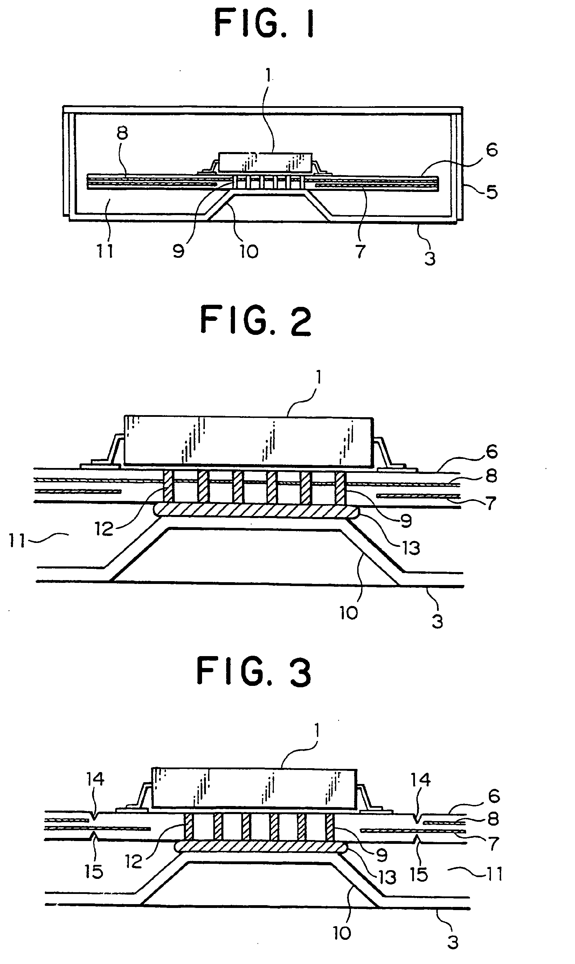

Embodiment 1, which is not an embodiment of the present invention, but helpful to understand certain aspects thereof, will be described with reference to FIG. 1. FIG. 1 is schematic structural diagram of an electronic apparatus provided with an electronic circuit substrate and portions similar to those in the conventional example will be denoted by similar reference numerals and the repeat description thereof will be omitted.

In FIG. 1, an electronic circuit substrate 6 comprises a resin wiring substrate with a wiring pattern 7 and a grounding pattern 8 formed in internal layers of the electronic circuit substrate 6. A plurality of through holes 9 are provided directly below a portion where a heat generating component 1 is mounted and are connected with the grounding pattern 8 in the electronic circuit substrate 6 by passing through the grounding pattern 8. A heat dissipating protruding surface portion 10 is formed as a portion of a case 3 by protruding one portion therefrom. The electronic circuit substrate 6 is disposed such that positions of the through holes 9 at a rear surface thereof contact a top of the heat dissipating protruding surface portion 10. A space 11 is formed between the rear surface of the electronic circuit substrate 6 and a surface of the case 3 surrounding the heat dissipating protruding surface portion 10. Moreover, this space 11 is set to a fixed size that enables low heat generating electrical/electronic components to be mounted to the rear surface of the electronic circuit substrate 6.

Thus, in Embodiment 1, heat generated by the heat generating component 1 is transferred to the entire case 3 via the heat dissipating protruding surface portion 10, which is in contact with the through holes 9, by way of the through holes 9 provided directly underneath the mounting portion of the heat generating component 1, and is dissipated to the outside from the case 3 which has the combined effect of a radiator. Also, by connecting the through holes 9 with the grounding pattern 8 formed in an internal layer of the electronic circuit substrate 6, it is possible to diffuse the heat generated by the heat generating component 1 in the electronic circuit substrate 6.

Furthermore, since heat dissipation may be performed in the heat generating component 1 by contacting only one portion of the rear surface of the electronic circuit substrate 6 with the case 3, low heat generating electrical/electronic components may also be mounted to the rear surface of the electronic circuit substrate 6 and it is possible to increase the conventional component packaging density by approximately twofold. Also, it is possible to obtain heat dissipating effects equal to or better than conventional examples by employing a circuit board made of resin such as an inexpensive glass epoxy and the like as the electronic circuit substrate 6 instead of an expensive ceramic substrate.

Hence, according to Embodiment 1, it is possible to realize an electronic apparatus provided with an electronic circuit substrate that is inexpensive, in which packaging density is high and which has good heat dissipating characteristics.

### Embodiment 2

Next, Embodiment 2, which is not an embodiment of the present invention, but helpful to understand certain aspects thereof, will be described with reference to FIG. 2. FIG. 2 is schematic structural diagram of an electronic apparatus provided with an electronic circuit substrate according to Embodiment 2 which is further improved over Embodiment 1. Moreover, portions similar to those in Embodiment 1 will be denoted by similar reference numerals and the repeat description thereof will be omitted.

In FIG. 2, a filler 12 of a material with high thermal conductivity, such as copper and the like, is filled in the through holes 9. A heat dissipating grease 13 composed of a material with high thermal conductivity is applied to a contact surface between an area where the through holes 9 of the rear surface of the electronic circuit substrate 6 are disposed and the heat dissipating protruding surface portion 10 of the case 3. Moreover, all other constructions are the same as in Embodiment 1.

In the electronic apparatus provided with an electronic circuit substrate constructed as described above, it is possible to transfer a large amount of heat generated from the heat generating component 1 to the case 3 by means of the filler 12 filled in the through holes 9 and the heat dissipating grease 13 which intervenes at the contact portion between the area where the through holes 9 of the rear surface of the electronic circuit substrate 6 are disposed and the heat dissipating protruding surface portion 10.

Thus, Embodiment 2 not only provides the same effects as in the above Embodiment 1, but it is also possible to realize an electronic apparatus provided with an electronic circuit substrate with even further improved heat dissipating characteristics.

### Embodiment 3

Next, Embodiment 3 according to the present invention will be described with reference to FIGS. 3 and 4. FIG. 3 is schematic structural diagram of an electronic apparatus provided with an electronic circuit substrate according to Embodiment 3 of the present invention which is further improved over Embodiment 2 and FIG. 4 is a partial plan view of the electronic circuit substrate according to Embodiment 3 of the present invention. Moreover, portions similar to those in Embodiment 2 will be denoted by similar reference numerals and the repeat description thereof will be omitted.

The above mentioned improvements will now be explained.
In the above mentioned Embodiment 2, as in the conventional example and Embodiment 1, since the entire electronic circuit substrate 6 is warmed by heat generated from the heat generating component 1 being diffused therein, there is a concern that heat stress will be given to other electronic components mounted on the electronic circuit substrate 6. This concern is particularly great when electronic components which are sensitive to temperature change are mounted in the vicinity of heat generating components. Embodiment 3 further overcomes the deficiencies of this sort in Embodiment 2.

In FIGS. 3 and 4, an insulating groove 14 comprising a concave groove of a V-shaped cross-section is formed in a front surface of the electronic circuit substrate 6 in an approximately square-shape so as to surround the vicinity of the heat generating component which constitutes an approximately square, planar shape. Moreover, an insulating groove 15 comprising a concave groove of a V-shaped cross-section similar to the insulating groove 14 is formed in the rear surface of the electronic circuit substrate 6 as well, and is formed in an approximately square-shape at a location opposite that of the insulating groove 14.
The grounding pattern 8 is removed in an area where the through holes 9 are disposed so as to not be connected with the through holes 9. Moreover, all other constructions are as in Embodiment 2.

In an electronic apparatus provided with an electronic circuit substrate of the above construction, the through holes 9 are not connected with the grounding pattern 8 and by further providing insulating grooves 14 and 15 in the front and rear surfaces of the electronic circuit substrate 6 at locations opposing each other, respectively, the heat generated from the heat generating component 1 is transferred to the case 3 via the through holes 9 without being transferred to the grounding pattern 8. Moreover, since the heat transferred by the resin substrate is also blocked by the insulating groove 14 surrounding the heat generating component 1 and the insulating groove 15 of the substrate rear surface, it is possible to reduce the heat stress given from the heat generating component 1 to electronic components in the vicinity of the heat generating component 1 while positively performing heat dissipation in the heat generating component 1 via the through holes 9 and the case 3.
Thus, Embodiment 3 of the present invention not only provides the same effects as in the above Embodiment 2, but since the constraints when mounting electronic/electrical components in the vicinity of the heat generating component 1 are further relaxed, it is also possible to realize the electronic apparatus provided with an electronic circuit substrate which is small in size and inexpensive.
Next, a variant of the above mentioned Embodiment 3 will be described. Although the above mentioned Embodiment 3 is described as an improvement on Embodiment 2, as in Embodiment 1, the present mode of Embodiment 3 may be constructed without the filler 12 filled in the through holes 9 and the heat dissipating grease 13 which intervenes at the contact portion between the area where the through holes 9 of the rear surface of the electronic circuit substrate 6 are disposed and the heat dissipating protruding surface portion 10.
However, in this case, although the structure may be simplified by not applying the filler 12 and the heat dissipating grease 13, a small reduction in the heat dissipating characteristics can not be avoided.

According to an aspect of the present invention an electronic apparatus provided with an electronic circuit substrate comprises:
an electronic circuit substrate comprising a resin wiring substrate formed with a wiring pattern and a grounding pattern in an internal layer thereof, a plurality of through holes provided directly below a portion where the heat generating component is mounted and which are not connected to the grounding pattern, and opposing insulating grooves formed in a front and rear surface of the electronic circuit substrate so as to surround the heat generating component, and
a case for protectively housing the electronic circuit substrate provided with a heat dissipating protruding surface portion contacting an area where the through holes of a rear surface of the electronic circuit substrate are disposed, and being formed so as to ensure a space between the case and the rear surface of the electronic circuit substrate for enabling mounting of low heat generating electrical/electronic components. Thus, as in the above embodiment, heat dissipation may be performed in the heat generating component by contacting only one portion of the rear surface of the electronic circuit substrate with the case, low heat generating electrical/electronic components may also be mounted to the rear surface of the electronic circuit substrate and it is possible to increase the conventional component packaging density by approximately twofold. Moreover, heat generated from the heat generating component does not spread in the entire wiring substrate via the grounding pattern and the heat transferred by the resin substrate is also blocked by the insulating groove surrounding the heat generating component and the insulating groove of the substrate rear surface. Consequently, it is possible to reduce the heat stress given from the heat generating component to electrical/electronic components in the vicinity of the heat generating component while positively performing heat dissipation in the heat generating component, and electronic components which are sensitive to temperature change may also be mounted in the vicinity of the heat generating component.
Hence, according to this aspect of the present invention, it is possible to realize the electronic apparatus provided with an electronic circuit substrate that is inexpensive and smaller in size.

According to the present invention there is provided an electronic apparatus provided with an electronic circuit substrate wherein:
a filler of a material with high thermal conductivity is filled in the plurality of through holes, and a heat dissipating grease intervenes at a contact portion between an area where the through holes of the electronic circuit substrate rear surface are disposed and the heat dissipating protruding surface portion of the case. Thus not only are the effects in the above aspects obtained, but it is also possible to transfer a large amount of heat generated by the heat generating component to the case.
   Hence, according to this aspect of the present invention, it is possible to realize an electronic apparatus provided with an electronic circuit substrate with further improved heat dissipating characteristics.
   Also, it is possible to obtain heat dissipating effects equal to or better than conventional examples by employing a wiring substrate made of resin, such as an inexpensive glass epoxy and the like, as the electronic circuit substrate instead of an expensive ceramic substrate.
   Hence, it is possible to realize the electronic apparatus provided with an electronic circuit substrate that is inexpensive, in which packaging density is high and which has good heat dissipating characteristics.

## Claims

1. An electronic apparatus provided with an electronic circuit substrate comprising:
an electronic circuit substrate (6) mounting a heat generating component (1), wherein a plurality of through holes (9) is formed directly below a portion where said heat generating component (1) is mounted,
a case (3) for protectively housing said electronic circuit substrate (6) and provided with an opening for housing said electronic circuit substrate (6), and
a cover (5) for blocking said opening of said case, wherein said case (3) comprises a heat dissipating protruding surface portion (10) contacting an area where said through holes (9) of said rear surface of said electronic circuit substrate (6) are disposed, and formed so as to ensure a space between portions of said case (3) other than said protruding surface portion (10) and said rear surface of said electronic circuit substrate (6) for enabling mounting of low heat generating electrical/electronic components to said rear surface of said electronic circuit substrate (6),
**characterized in that**,
said electronic circuit substrate (6) comprises
a resin wiring substrate formed with a wiring pattern (7) and a grounding pattern (8) in an internal layer thereof, wherein said plurality of through holes (9) is not connected to said grounding pattern (8),
an insulating groove (14) comprising a concave groove formed in a front surface of said substrate (6) mounting said heat generating component (1) so as to surround said heat generating component (1), and
an insulating groove also comprising a concave groove (15) being formed in a rear surface of said substrate (6) at a location opposite that of said groove (14) in said substrate front surface.

2. An electronic apparatus provided with an electronic circuit substrate (6) according to claim 1 **characterized in that**
a filler (12) of a material with high thermal conductivity is filled in said plurality of through holes (9), and a heat dissipating grease (13) intervenes at a contact portion between an area where said through holes (9) of said electronic circuit substrate rear surface are disposed and said heat dissipating protruding surface portion (10) of said case.

## Patentansprüche

1. Elektronisches Gerät, das mit einem Substrat für eine elektronische Schaltung versehen ist, welches aufweist:
ein Substrat (6) für eine elektronische Schaltung, auf dem eine Wärme erzeugende Komponente (1) befestigt ist, in welchem mehrere Durchgangslöcher (9) direkt unter einem Bereich, in welchem die Wärme erzeugende Komponente (1) befestigt ist, ausgebildet sind,
ein Gehäuse (3) zum schützenden Aufnehmen des Substrats (6) für eine elektronische Schaltung, das mit einer Öffnung zur Aufnahme des Substrats (6) für eine elektronische Schaltung versehen ist, und
eine Abdeckung (5) zum Blockieren der Öffnung des Gehäuses, wobei das Gehäuse (3) einen vorstehenden, Wärme ableitenden Oberflächenbereich (10) aufweist, der eine Fläche kontaktiert, in der sich die Durchgangslöcher (9) der rückseitigen Oberfläche des Substrats (6) für eine elektronische Schaltung befinden, und so ausgebildet ist, dass ein Raum zwischen anderen Bereichen des Gehäuses (3) als dem vorstehenden Oberflächenbereich (10) und der rückseitigen Oberfläche des Substrats (6) für eine elektronische Schaltung sichergestellt ist, um die Befestigung von niedrigen, Wärme erzeugenden elektrischen/elektronischen Komponenten auf der rückseitigen Oberfläche des Substrats (6) für eine elektronische Schaltung zu ermöglichen,
**dadurch gekennzeichnet, dass**
das Substrat (6) für eine elektronische Schaltung aufweist:
ein Harzverdrahtungssubstrat, das mit einem Verdrahtungsmuster (7) und einem Erdungsmuster (8) in einer inneren Schicht hiervon ausgebildet ist, wobei die mehreren Durchgangslöcher (9) nicht mit dem Erdungsmuster (8) verbunden sind,
eine isolierende Nut (14), die eine konkave Nut aufweist, die in einer vorderen Oberfläche des Substrats (6), auf dem die Wärme erzeugende Komponente (1) befestigt ist, ausgebildet ist, derart, dass sie die Wärme erzeugende Komponente (1) umgibt, und
eine isolierende Nut, die auch eine konkave Nut (15) aufweist, die in einer rückseitigen Oberfläche des Substrats (6) an einer Stelle gegenüber der der Nut (14) in der vorderen Oberfläche des Substrats ausgebildet ist.

2. Elektronisches Gerät, das mit einem Substrat (6) für eine elektronische Schaltung versehen ist, nach Anspruch 1, **dadurch gekennzeichnet, dass**
ein Füllstoff (12) aus einem Material mit hoher thermischer Leitfähigkeit in die mehreren Durchgangslöcher (9) gefüllt ist und ein Wärme ableitendes Fett (13) in einem Kontaktbereich zwischen einer Fläche, in der sich die Durchgangslöcher (9) in der rückseitigen Oberfläche des Substrats für eine elektronische Schaltung befinden, und dem vorstehenden, Wärme ableitenden Oberflächenbereich (10) des Gehäuses angeordnet ist.

## Revendications

1. Appareil électronique muni d'un substrat de circuit électronique comprenant :
un substrat de circuit électronique (6) sur lequel est monté un composant qui produit de la chaleur (1), dans lequel une pluralité de trous traversants (9) sont formés directement sous une partie où est monté ledit composant qui produit de la chaleur (1),
un boîtier (3) destiné à loger de façon protectrice ledit substrat de circuit électronique (6) et doté d'une ouverture destinée à loger ledit substrat de circuit électronique (6), et
un capot (5) destiné à bloquer ladite ouverture dudit boîtier, dans lequel ledit boîtier (3) comprend une partie de surface qui fait saillie et qui dissipe la chaleur (10) en contact avec une zone où sont disposés lesdits trous traversants (9) de ladite surface arrière dudit substrat de circuit électronique (6), et qui est formé de manière à assurer un espace entre lesdites parties dudit boîtier (3) autres que ladite partie de surface qui fait saillie (10) et ladite surface arrière dudit substrat de circuit électronique (6) de manière à permettre le montage de composants électriques / électroniques qui produisent peu de chaleur sur ladite surface arrière dudit substrat de circuit électronique (6),
**caractérisé en ce que**,
ledit substrat de circuit électronique (6) comprend :
un substrat de câblage en résine formé avec un motif de câblage (7) et un motif de mise à la terre (8) dans une couche intérieure de celui-ci, dans lequel ladite pluralité de trous traversants (9) ne sont pas connectés audit motif de mise à la terre (8),
une rainure isolante (14) qui comprend une rainure concave formée dans une surface avant dudit substrat (6) sur lequel est monté ledit composant qui produit de la chaleur (1) de manière à entourer ledit composant qui produit de la chaleur (1), et
une rainure isolante qui comprend également une rainure concave (15) formée dans une surface arrière dudit substrat (6) au niveau d'un emplacement opposé à celui de ladite rainure (14) dans ladite surface avant du substrat.

2. Appareil électronique muni d'un substrat de circuit électronique (6) selon la revendication 1, **caractérisé en ce que** :
un matériau de remplissage (12) qui présente une conductivité thermique élevée, remplit ladite pluralité de trous traversants (9), et une graisse de dissipation de la chaleur (13) intervient au niveau d'une partie de contact entre une zone où sont disposés lesdits trous traversants (9) de ladite surface arrière du substrat de circuit électronique, et la partie de surface qui fait saillie et qui dissipe la chaleur (10) dudit boîtier.
